# EUROPEAN PATENT APPLICATION

(11) **EP 1 435 766 A1**
(43) Date of publication of application: **07.07.2004**
(21) Application number: 02425799.0
(22) Date of filing: 30.12.2002
(51) Int. Cl.: H05K 5/03

(54) **Portable electronic device housing**

(71) Applicant: MOTOROLA, INC., Schaumburg, IL 60196 (US)
(72) Inventor: Verdinelli, Fabio, Motorola Technology Center, 10147 Torino (IT); D'Ippolito, Gianfelice, Motorola Technology Center, 10147 Torino (IT); Marziantonio, Daniela, Motorola Technology Center, 10147 Torino (IT)
(74) Representative: Gibson, Sarah Jane

(57) **Abstract**

The present invention relates to a portable electronic device housing, having a cover (40). At least part of the cover (40) is flexible and the cover (40) is moveable between a shut position and an open position substantially without change in the dimensions of the housing. Preferably, a flexible curtain portion (41 ) of the cover (40) is wound up in the open position and is extended in the shut position.

## Description

The present invention relates to a portable electronic device housing, having a cover, in particular for a communication device. The present invention relates in particular to an at least partially flexible cover for an electronic device that enables the screen or a keypad of the electronic device to be protected from shocks or scratches.

Many different housings for electronic devices having a cover to protect the electronic device from damage are known. In one arrangement, commonly found in Personal Digital Assistants (PDAs), a rigid cover is attached along one side of the PDA and opens in a book-like manner when the PDA is in use. However, the rigid cover may be bulky and can interfere with easy use of the PDA. In other arrangements, such as a clam form factor or a U-flip form factor, two housing portions are connected by a hinge and are able to rotate between an open and a shut position.

The present invention seeks to provide an alternative cover arrangement for a portable electronic device.

According to the present invention, there is provided a portable electronic device housing having a cover for covering at least part of the electronic device, wherein at least part of the cover is flexible and the cover is moveable between a shut position and an open position substantially without change in the dimensions of the housing.

This arrangement provides a particularly compact and appealing cover arrangement for a portable electronic device, which nevertheless provides protection against knocks and scratches as well as protection against dust or grease left by fingers or accidental spillages of liquids.

The present invention is particularly applicable to small portable electronic devices such as mobile phones or PIDAs, but is useful for any portable electronic device such as, but not limited to, any cellular radio, laptop computer or camera, for example.

Advantageously, a flexible curtain portion of the cover is wound up in the open position and is extended in the shut position. This arrangement provides a particularly compact mechanism for the cover. In one embodiment of the invention the cover comprises two cover portions.

Part of the cover may be rigid. The rigid part of the cover is preferably arranged to cover areas of the housing that require particular protection, for example a display. Additionally or alternatively, the cover may at least partially comprise a flexible film. Additionally or alternatively, at least part of the cover may be formed from linked sections. This arrangement of the cover provides a high level of protection, since the linked sections may be made semi-rigid, while also providing the necessary degree of flexibility of the cover.

Preferably, the housing has a mechanism for at least semi-automatically moving the cover from a shut position to an open position. This may be achieved by using a spring-loaded cover and a latch, such that when the latch is released by the user of the electronic device, the cover automatically opens. Thus the operation of the electronic device is made easier.

Advantageously, at least one man-machine-interface element is covered by the cover in the shut position. For example, a keyboard can be covered, and therefore locked, by the cover in the shut position. This can prevent unauthorized or accidental activation of the keyboard. Alternatively or additionally, a display may be covered by the cover in the shut position. Again, unauthorized or accidental activation of touch-screen display may be prevented, as well as damage to the display caused by knocks or scratches.

Preferably the at least one man-machine-interface element is a display. The importance of protecting the display of a portable electronic device such as a mobile telephone or a Personal Digital Assistant is likely to increase as large colour screens, which are expensive and particularly vulnerable to damage from knocks and scratches, are introduced.

In order to allow the user to personalize the electronic device by replacing or updating the cover, in an advantageous embodiment of the invention the cover may be detachable from the housing.

For a better understanding of the present invention, and to show how it may be brought into effect, reference will now be made, by way of example, to the accompanying drawings, in which:
Figure 1a shows a housing in accordance with a first embodiment of the invention with a cover in an open position;
Figure 1b shows the housing as shown in Figure 1a with the cover in an shut position;
Figure 2a shows an exploded view of a spring mechanism used in the housing shown in Figures 1a and 1b;
Figure 2b shows an assembled view of the spring mechanism shown in Figure 2a;
Figures 3a and 3b illustrate a latching mechanism used in the housing shown in Figures 1a and 1b;
Figure 4 shows a housing in accordance with a second embodiment of the invention;
Figures 5 shows a housing in accordance with a third embodiment of the invention.

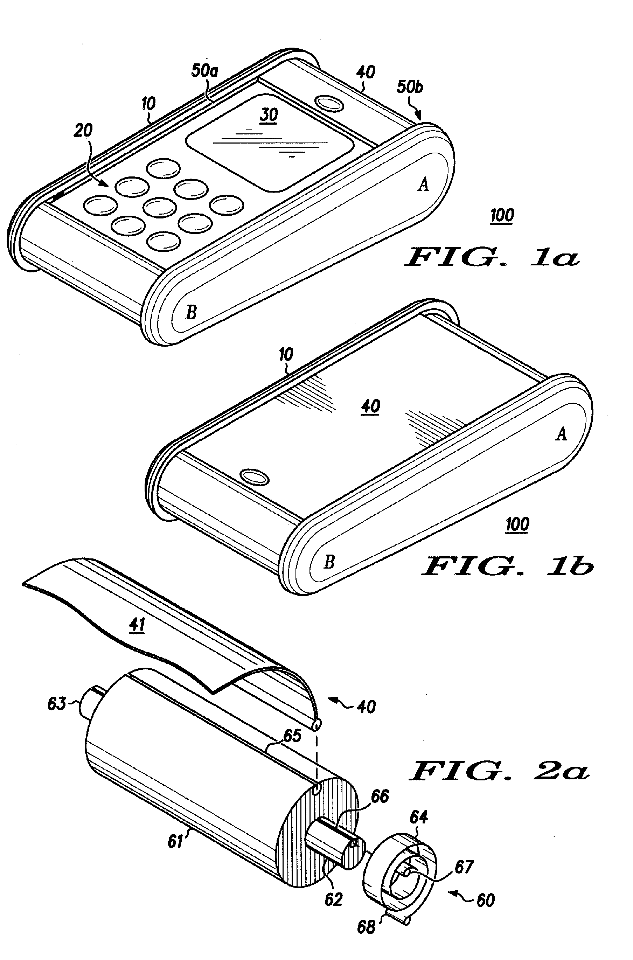

As shown in Figures 1a and 1b, an exemplary portable electronic device 100 has a housing 10 in accordance with a first embodiment of the invention. The housing 10 of the exemplary illustrated embodiment is generally rectilinear, however, it should be appreciated that this is not necessary and the housing 10 may be other shapes.

The housing 10 has Man Machine Interface (MMI) elements thereon. In the illustrated exemplary embodiment of the invention, the MMI elements comprise at least a keyboard 20 and a screen 30. Although in preferred embodiments of the invention the electronic device is provided with a keyboard 20 and a screen 30 as MMI elements, it will be known to a skilled person that these elements are not always necessary. For example, the screen 30 may be a touch-sensitive screen, in which case it may be possible to dispense with the keyboard 20. Additionally or alternatively, the MMI elements may include a microphone and/or a speaker if the electronic device is a communication device and/or if voice recognition is supported by the electronic device. Additionally or alternatively, the MMI elements may include: a joystick; touch pad; trackball; digital camera, for example.

The housing 10 has an at least partially flexible cover 40 in accordance with the invention. In Figure 1a, cover 40 is in an open position, in which at least some of the MMI elements of the electronic device, in the exemplary embodiment the keyboard 20 and the screen 30, are uncovered and available for use. In this position of the cover, the electronic device is available for use. In Figure 1b, the cover 40 is in a shut or closed position, in which the above-mentioned MMI elements of the electronic device, i.e. the keyboard 20 and the screen 30 in the exemplary described embodiment, are covered and unavailable for use. In this position of the cover 40, at least some and preferably all of the functions of the electronic device are not available for use.

The cover 40 may be formed from as a thin flexible film, or from linked or interlocking segments, for example in the manner of a shutter. Other arrangements are also possible, as will be known to a skilled person. The cover 40 may be flexible throughout its entire length, or the cover 40 may be provided with at least one rigid section. In addition, the flexible cover may be transparent, opaque or colored within the competence of a skilled person. The cover 40 may be made of any suitable material, as will be apparent to a skilled person, such as rubber, plastics or sheet metal, such as aluminium.

The housing 10 is provided with guide groove 50a and corresponding guide groove 50b (not clearly visible in Figures 1a and 1b) therein to accommodate the edges of flexible cover 40 in the shut or closed position, as illustrated in Figure 1b, and to guide movement of the flexible cover 40 between the shut or closed position and the open position.

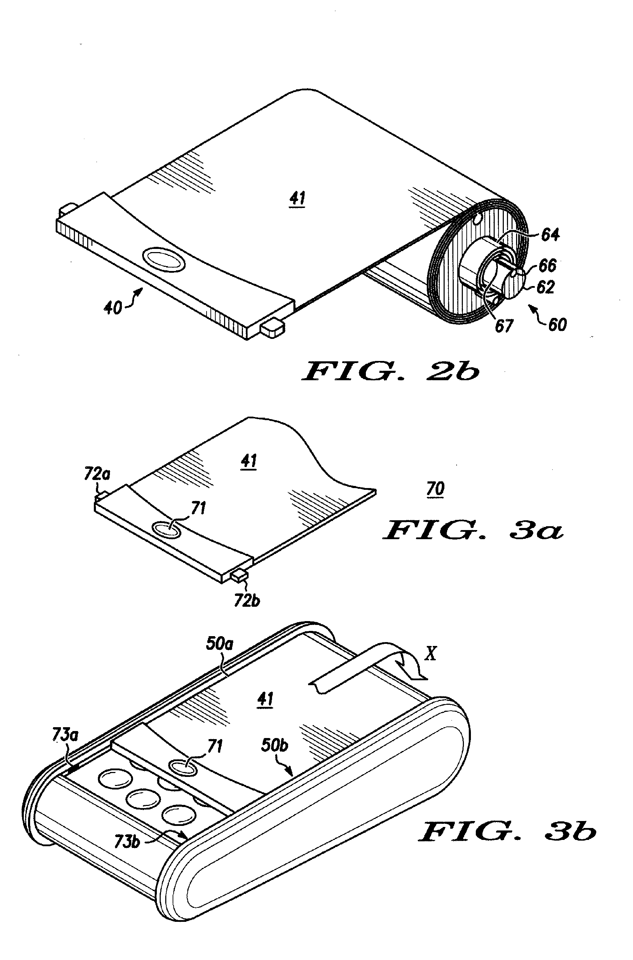

In the illustrated exemplary embodiment, the housing 10 is provided at a first end A thereof with a spring mechanism 60 (not shown) for the cover 40, which will be described hereafter with reference to Figures 2a and 2b, and at a second end B thereof is provided with a latch mechanism 70, which will be described with reference to Figures 3a and 3b.

Figure 2a is an expanded view of an exemplary spring mechanism 60 and Figure 2b is a view of the exemplary spring mechanism 60 in an assembled state. As shown in Figure 2a, the exemplary spring mechanism 60 has a first cylindrical portion 61, a second cylindrical portion 62, a third cylindrical portion 63 and a spring 64. The first cylindrical portion 61 has a first longitudinal groove 65 formed therein for receiving the edge of the curtain of the cover 40, as shown. The second cylindrical portion 62 has a second longitudinal groove 66 formed therein for receiving a first end 67 of the spring 64. A second end 68 of the spring is attached to the housing 1 0 (not shown).

Figure 2b shows the assembled state of the spring mechanism 60. The first end 67 of the spring 64 is fitted to the second longitudinal groove 66 formed in the second cylindrical portion 62, and the spring 64 is wrapped around the second cylindrical portion 62, leaving the second end 68 free for attachment to the housing 10. As indicated above, the edge of the curtain of the cover 40 is fitted to the first longitudinal groove 64 of the first cylindrical portion 61, and the majority of the remainder of the curtain portion of the cover 40 is wrapped around the first cylindrical portion 61.

The spring mechanism 60 and cover 40 may then be mounted in housing 10 by way of second cylindrical portion 62 and third cylindrical portion 63, and the second end 68 of the spring 64 attached to the housing 10, as will be appreciated by a skilled person. The spring 64 is arranged such that the spring 64 exerts a rotational force on the second cylindrical portion 62 tending to roll up the curtain portion of the cover 40.

In a preferred embodiment of the invention, the cover is detachable from the housing. For example, the cylindrical portions 62, 63 may be dismounted from the housing so that the cover may be removed from the housing. A new cover may be fitted to the housing in its place. In this way, the user may personalize or customize the cover of the portable electronic device housing.

The latching mechanism will now be explained with reference to Figures 3a and 3b.

Figure 3a shows the end of the curtain portion of the cover 40, which carries an exemplary latching mechanism 70 comprising an actuator button 71 and retractable tabs 72a and 72b. When the actuator button 71 is pressed, the retractable tabs 72a and 72b are retracted, for example to be flush with the edges of the curtain portion of the cover 40, and when the actuator button 71 is released, the retractable tabs 72a and 72b are extended so as to protrude from the edges of the curtain portion of the cover 40.

Figure 3b shows the housing 1 0 with the cover 40 almost completely shut. The guide groove 50a has a recess 73a formed therein for receiving the retractable tab 72a when the cover 40 is in the shut position. Similarly corresponding guide groove 50b (not clearly visible in Figure 3b) has a corresponding recess 73a formed therein for receiving the retractable tab 72b when the cover 40 is in the shut position.

Thus, when the cover is in the shut position, as shown in Figure 1b, retractable tabs 72a, 72b are received in the recesses 73a and 73b and hold the cover 40 shut under tension caused by the force exerted by the spring 64 on the cover 40 by means of the cylindrical portions 61, 62, 63.
When the user of the electronic device wishes to use the device, the user presses actuator button 71. The retractable tabs 72a and 72b are thus retracted and the tension caused by the force exerted by the spring 64 on the cover 40 by means of the cylindrical portions 61, 62, 63 results in the cover 40 moving automatically from the shut position to the open position in the direction X as shown in Figure 3b. The cover 40 is guided during this movement by the guide grooves 50a, 50b. The cover 40 is wound around first cylindrical portion 61, as shown in Figure 2b.

After use, the user can draw the cover 40 back from the open position to the shut position along the guide grooves 50a, 50b. As the cover 40 is moved towards the shut position, the cover 40 is unwound from the first cylindrical portion 61 resulting in increasing tensioning of the spring 64. Once the shut position is reached, the retractable tabs 72a, 72b re-engage with the recesses 73a, 73b to shut the electronic device.

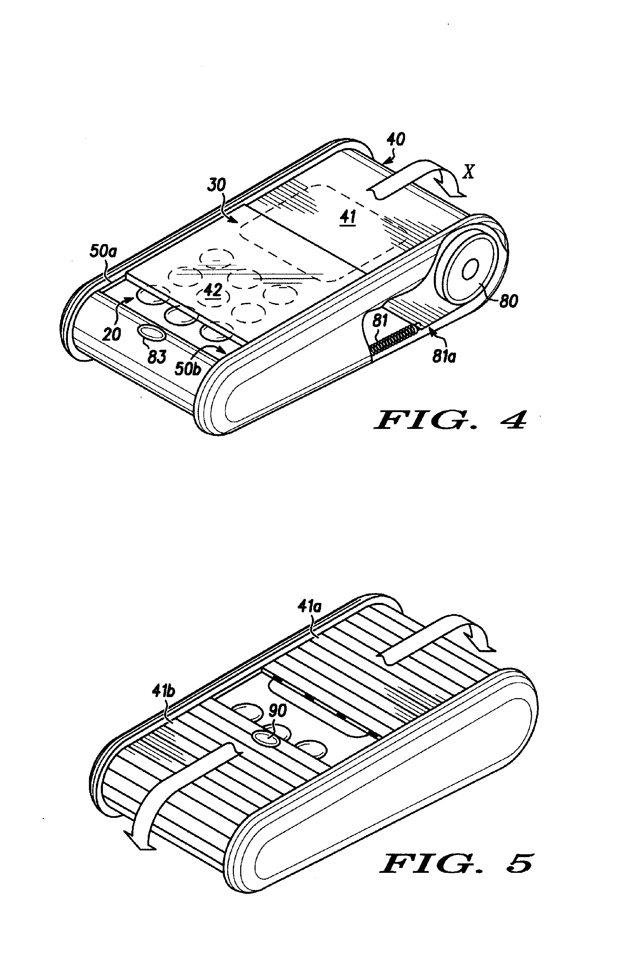

Figure 4 is a partially cutaway view showing a housing in accordance with an alternative embodiment of the invention. Elements that are similar to the elements in the first embodiment of the invention have been given the same reference numerals.

In this alternative embodiment of the invention, a rigid portion 42 of the cover 40 is provided in addition to the curtain portion 41, as described previously. In addition, instead of the spring mechanism 60 described previously with reference to Figures 2a and 2b, a belt pulley 80 and spring 81 mechanism is provided. Spring 81 and a corresponding spring on the other side of the housing, is attached at one end to the housing (not shown) and at the other end 81 a to the curtain portion 41 of the cover 40. The curtain portion 41 of the cover 40 is then wrapped around belt pulley 80. Finally, a central latching mechanism 83 is provided, as will be known to a skilled person.

Thus, when the cover 40 is in the shut position, the rigid portion 42 of the cover 40 covers the lower portion of the top face of the housing, for example covering a keyboard 20, and the flexible curtain portion 41 of the cover 40 covers the upper portion of the top face of the housing, for example covering a display 30. Latching mechanism 83 holds the cover 40 shut against the tension caused by the force exerted by the spring 81 and its corresponding spring (not shown) on the cover 40.

When the user of the electronic device wishes to use the device, the user releases the latching mechanism 83. The tension caused by the force exerted by spring 81 and its corresponding spring (not shown) on the cover 40 results in the cover 40 moving automatically from the shut position to the open position in the direction X as shown in Figure 4. The cover 40 is guided during this movement by the guide grooves 50a, 50b. The flexible curtain portion 41 of the cover 40 winds round or is wrapped around the belt pulley 80 and the rigid portion 42 is moved to cover the upper portion of the top face of the housing, for example the display 30.

After use, the user can draw the cover 40 back from the open position to the shut position along the guide grooves 50a, 50b. As the cover 40 is moved towards the shut position, the flexible curtain portion 41 of the cover 40 unwinds around or unwraps from belt pulley 80 resulting in increasing tensioning of the spring 81 and its corresponding spring. Once the shut position is reached, the latching mechanism 83 shuts the electronic device.

Figure 5 shows a housing in accordance with a further alternative embodiment of the invention. Elements that are similar to the elements in the first and second embodiments of the invention have been given the same reference numerals.

In this alternative embodiment of the invention, two flexible curtain portions 41a, 41b are provided, with a latching mechanism 90. Each of the flexible curtain portions 41a, 41b is provided with an opening mechanism, such as the spring mechanism described with reference to Figures 2a and 2b or the belt and pulley arrangement described with reference to Figure 4 or any other suitable arrangement as will occur to a skilled person.

In this embodiment of the invention, the flexible curtain portions 41a, 41b of cover 40 are formed from linked segments. Thus, although each segment is rigid or semi-rigid, the curtain portion as a whole can be made sufficiently flexible to be wound around the belt pulley 80 or the first cylindrical portion 61.

When the user of the electronic device wishes to use the device, the user releases the latching mechanism 83. The flexible curtain portions 41a, 41b of cover 40 each moves automatically from the shut position to the open position under the action of the respective opening mechanism, such as the spring mechanism described with reference to Figures 2a and 2b or the belt and pulley arrangement described with reference to Figure 4. The flexible curtain portions 41a 41b of cover 40 are guided during this movement by the guide grooves 50a, 50b.

After use, the user can draw the flexible curtain portions 41a, 41b of the cover 40 back from the open position to the shut position along the guide grooves 50a, 50b. Once the shut position is reached, the latching mechanism 83 shuts the electronic device.

The invention is not limited to the described embodiments. In particular, it should be noted that the linked section arrangement of the flexible cover might be used in a single-cover arrangement in addition to the twin-cover arrangement as described. It is preferable but not essential that a linked section cover is used with a pulley wrap-around arrangement, such as that described with reference to Figure 4, rather than a wrap-up arrangement such as shown with reference to Figure 2a and 2b.

The electronic device may be provided with independently operable covers. In a particularly advantageous arrangement, independently operable covers are provided on opposing sides of the device. This arrangement is of particular value for devices with dual function, such as a combined PDA and communication device.

Clearly, in the embodiment described with reference to Figures 1-3 the wind-up mechanism may be at end A or at end B of the device, as shown. In addition, the embodiment of the invention in which the cover includes a rigid portion may utilize any opening mechanism, such as the spring mechanism described with reference to Figures 2a and 2b or the belt and pulley arrangement described with reference to Figure 4 or any other suitable arrangement as will occur to a skilled person.

Moreover, although opening mechanisms have been described in which the opening of the cover is achieved at least semi-automatically, and the shutting of the cover is achieved by manual actuation by the user, mechanisms for automatic/semi-automatic or manual opening and/or closing operation will be known to a skilled person and are intended to be included within the scope of the invention.

The invention provides a preferable portable electronic device housing.

## Claims

1. A portable electronic device housing (10) having a cover (40) for covering at least part of the electronic device (100), wherein at least part of the cover (40) is flexible and the cover (40) is moveable between a shut position and an open position substantially without change in the dimensions of the housing (10).

2. The housing (10) as claimed in claim 1, wherein a flexible curtain portion (41) of the cover (40) is wound up in the open position and is extended in the shut position.

3. The housing (10) as claimed in any preceding claim wherein the cover (40) comprises two cover portions (41 a,41 b).

4. The housing (1 0) as claimed in any preceding claim wherein part (42) of the cover (40) is rigid.

5. The housing (10) as claimed in any preceding claim, wherein the cover (40) at least partially comprises a flexible film.

6. The housing (10) as claimed in any preceding claim, wherein the at least part of the cover (40) is formed from linked sections.

7. The housing (10) as claimed in any preceding claim further comprising a mechanism (61-68, 80, 81) for at least semi-automatically moving the cover (40) from a shut position to an open position.

8. The housing (10) as claimed in any preceding claim wherein at least one man-machine-interface element (20, 30) is covered by the cover in the shut position.

9. The housing (10) as claimed in claim 8 wherein said at least one man-machine-interface element is a display (30).

10. The housing (10) as claimed in any preceding claim wherein the cover (40) is detachable from the housing.

11. A portable electronic device having a housing (10) as claimed in any preceding claim.

12. A communication device having a housing (10) as claimed in any one of claims 1-10.

13. A personal digital assistant having a housing (10) as claimed in any one of claims 1 -10.
